# EUROPEAN PATENT SPECIFICATION

(11) **EP 0 504 987 B1**
(45) Date of publication and mention of the grant of the patent: **04.10.1995**
(21) Application number: 92200708.3
(22) Date of filing: 12.03.1992
(51) Int. Cl.: H01L 21/265, H01L 21/74

(54) **Method of manufacturing a semiconductor device having a semiconductor body with a buried silicide layer**
Verfahren zum Herstellen einer Halbleiteranordnung mit einem Halbleiterkörper mit einer vergrabenen Silicidschicht
Procédé de fabrication d'un dispositif semiconducteur comportant un corps semiconducteur pourvu d'une couche enterrée de siliciure

(30) Priority: 21.03.1991 EP 91200635
(43) Date of publication of application: 23.09.1992
(73) Proprietor: Philips Electronics N.V., 5621 BA Eindhoven (NL)
(72) Inventor: Van Ommen, Alfred Hendrik, NL-5656 AA Eindhoven (NL); Ottenheim, Jozef Jacobus Maria, NL-5656 AA Eindhoven (NL); De Kempeneer, Erik Hendrik Adolf, NL-5656 AA Eindhoven (NL); Van Hoften, Gerrit Cornelis, NL-5656 AA Eindhoven (NL)
(74) Representative: Rensen, Jan Geert

(56) References cited:
- EP-A- 0 259 282
- EP-A- 0 259 282
- EP-A- 0 271 232
- US-A- 3 726 719
- US-A- 4 875 082
- NUCLEAR INSTRUMENTS & METHODS IN PHYSICS RESEARCH SECTION B vol. B17, no. 4, November 1986, AMSTERDAM NL pages 331 - 333; M. KALITZOVA ET AL.: 'Thermal regrowth of silicon after high-dose Ar+ implantation'
- EXTENDED ABSTRACTS/ELECTROCHEMICAL SOCIETY vol. 87-2, 1987, PRINCETON, NEW JERSEY US pages 968 - 969; MICHAEL N. KOZICKI: 'Silicide formation by direct metal implantation'

## Description

The invention relates to a method of manufacturing a semiconductor device whereby ions are implanted in a monocrystalline silicon body in order to obtain a buried silicide layer.

A method of this kind is known from EP-A-271.232.

The buried silicide layers obtained by means of the known method have the disadvantage, that they are too thick for many applications. They are unsuitable, for example, for so-called metal-base transistors in which the silicide buried layer serving as the base must be thinner than 10 nm.

The invention has for its object to avoid said disadvantage at least to a considerable degree and is based on the insight that it is effective to form a buried amorphous layer prior to the implantation of the element with which silicon of the silicon body is to form the buried silicide. EP-A-259282 discloses a method of forming a buried silicide layer suitable for a metal base transistor, characterized by implanting metal atoms in a silicon substrate and by subjecting the silicon substrate to heat treatment. Silicon atoms are implanted to the same depth as the metal prior to carrying out the heat treatment, in the cases where the implanted metal forms with silicon or compound which occuptes a smaller specific volume than silicon.

According to the invention, therefore the method mentioned in the opening paragraph is characterized in that
a) first a buried amorphous layer is formed by implanting a different element than that with which silicon of the silicon body is to form the buried silicide subsequently,
b) then the element with which silicon of the silicon body is to form the buried silicide layer is implanted and
c) subsequently the buried silicide layer is formed by a heat treatment.

Ions are often better soluble in amorphous silicon than in monocrystalline silicon. During the heat treatment in which the silicide is formed, a buried silicide layer is formed whose thickness is smaller than that of the amorphous layer formed by implanting the different element.

The amorphous buried layer can be formed by implantation of silicon or by implantation of a rare gas.

Preferably the element with which silicon of the silicon body is to form the buried silicide layer is Cobalt.

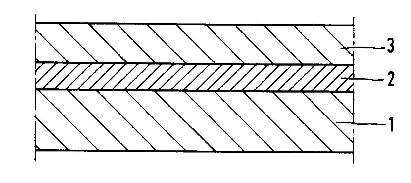

The invention will now be explained with reference to an embodiment and the accompanying Figure, which diagrammatically and in cross-section represents a portion of a semiconductor device in a stage of manufacture by means of the method according to the invention.

In the present method, the aim is to manufacture a semiconductor device, for example, a metal-base transistor in which ions are implanted in a monocrystalline silicon body 1 (see Figure) in order to obtain a buried silicide layer 2.

According to the invention, a buried amorphous layer is first formed in the implantation, after which the buried silicide layer 2 is formed by a heat treatment.

The amorphous layer is formed by implantation of a different element than that with which silicon of the silicon body is to form the buried silicide layer 2 subsequently. This other element may be, for example, a rare gas, for example argon, or it may be silicon.

An amorphous silicon layer may be formed, for example, by means of a random implantation with a dose of 2,9 x 10¹⁴ silicon atoms per cm² at an energy of 500 keV at a temperature of 80 K, whereby the amorphous silicon layer is given a thickness of 540 nm underneath a 200 nm thick top layer of monocrystalline silicon 3.

To obtain a cobalt disilicide (CoSi₂) layer having a thickness of 10 nm, a cobalt implantation is necessary of approximately 2,6 x 10¹⁶ cobalt atoms per cm². This may be done in a usual manner.

It should be noted that amorphous silicon provides a high solubility for cobalt atoms.

During the ensuing heat treatment, the amorphous silicon layer of 540 nm is converted into a cobalt silicide layer of 10 nm. The heat treatment takes, for example, four hours at 575° C and 0,5 hour at 1.000° C.

In the metal-base transistor, which may be manufactured in usual manner in all other respects, the layer 3 acts as the emitter and the silicon body 1 as the collector.

The present invention is obviously not limited to the example given, but may be varied in many ways by those skilled in the art. Instead of a cobalt disilicide layer, for example, a buried nickel disilicide layer may be formed. It is also possible to manufacture a permeable-base transistor by means of the method according to the invention.

## Claims

1. A method of manufacturing a semiconductor device whereby ions are implanted in a monocrystalline silicon body in order to obtain a buried silicide layer, characterized in that,
a) first a buried amorphous layer is formed by implanting a different element than that with which silicon of the silicon body is to form the buried silicide subsequently,
b) then the element with which silicon of the silicon body is to form the buried silicide layer is implanted and
c) subsequently the buried silicide layer is formed by a heat treatment.

2. A method as claimed in claim 1, characterized in that the amorphous buried layer is formed by implantation of silicon.

3. A method as claimed in claim 1, characterized in that the amorphous buried layer is formed by implantation of a rare gas.

4. A method as claimed in claim 1, characterized in that the element with which silicon of the silicon body is to form the buried silicide layer is Cobalt.

## Patentansprüche

1. Verfahren zur Herstellung einer Halbleiteranordnung bei dem in einen einkristallinen Siliciumkörper Ionen implantiert werden, um eine vergrabene Silicidschicht zu erhalten, dadurch gekennzeichnet, daß
a) durch Implantieren eines anderen Elements als desjenigen, mit dem das Silicium des Siliciumkörpers anschließend die vergrabene Silicidschicht bilden soll, erst eine vergrabene amorphe Schicht gebildet wird,
b) dann das Element, mit dem das Silicium des Siliciumkörpers die vergrabene Silicidschicht bilden soll, implantiert wird und
c) anschließend die vergrabene Silicidschicht durch eine Wärmebehandlung gebildet wird.

2. Verfahren nach Anspruch 1, dadurch gekennzeichnet, daß die amorphe Schicht durch Implantation von Silicium gebildet wird.

3. Verfahren nach Anspruch 1, dadurch gekennzeichnet, daß die amorphe Schicht durch Implantation von Edelgas gebildet wird.

4. Verfahren nach Anspruch 1, dadurch gekennzeichnet, daß das Element, mit dem das Silicium des Siliciumkörpers die vergrabene Silicidschicht bilden soll, Cobalt ist.

## Revendications

1. Procédé pour la fabrication d'un dispositif semiconducteur selon lequel des ions sont implantés dans un corps en silicium monocristallin pour obtenir une couche enterrée en siliciure, caractérisé en ce que
a) d'abord une couche amorphe enterrée est formée par implantation d'un élément autre que celui avec lequel le silicium du corps en silicium forme ultérieurement le siliciure enterré,
b) ensuite l'élément avec lequel le silicium du corps en silicium forme la couche enterrée en siliciure est implanté et
c) la couche enterrée en siliciure est ensuite formée par un traitement thermique.

2. Procédé selon la revendication 1, caractérisé en ce que la couche amorphe enterrée est formée par implantation de silicium.

3. Procédé selon la revendication 1, caractérisé en ce que la couche enterrée amorphe est formée par implantation d'un gaz rare.

4. Procédé selon la revendication 1, caractérisé en ce que l'élément avec le silicium du corps en silicium forme la couche enterrée en siliciure est du cobalt.
